# EUROPÄISCHE PATENTSCHRIFT

(11) **EP 3 761 335 B1**
(45) Veröffentlichungstag und Bekanntmachung des Hinweises auf die Patenterteilung: **16.04.2025**
(21) Anmeldenummer: 19184433.1
(22) Anmeldetag: 04.07.2019
(51) Int. Cl.: H01H 9/52, H03K 17/082, H01H 9/54, H01H 71/02, H01H 71/32, H01H 71/50, H01H 71/56, H03K 17/51

(54) **ELEKTRONISCHES SCHALTGERÄT**
ELECTRONIC SWITCHING DEVICE
APPAREIL DE COMMUTATION ÉLECTRONIQUE

(43) Veröffentlichungstag der Anmeldung: 06.01.2021
(73) Patentinhaber: Siemens Aktiengesellschaft, 80333 München (DE)
(72) Erfinder: Feil, Wolfgang, 92421 Schwandorf (DE); Kreutzer, Rainer, 92637 Weiden (DE)
(74) Vertreter: Siemens Patent Attorneys

(56) Entgegenhaltungen:
- EP-A1- 2 234 136
- WO-A1-2014/110625

## Beschreibung

Die Erfindung betrifft ein Schaltgerät mit einer ersten und einer zweiten Schaltstelle.

Es gibt in der Entwicklung von elektronischen Schaltgeräten Modifikationen, welche eine Halbleiterschaltstelle mit einem mechanischen Kontakt kombinieren. Man unterscheidet dabei zwischen mechanischen Schaltkontakten, welche parallel zu einer Transistoranordnung geschaltet sind und solchen, welche in Reihe dazu geschaltet sind. Es gibt auch Produktsegmente mit Schaltgeräten, welche sowohl seriell als auch parallel geschaltete mechanische Schaltstellen aufweisen. Das Bedienelement dieser Schaltgeräte wirkt hier direkt auf den parallelen Kontakt, bzw. die mechanischen Kontakte sind als Relais-Kontakte ausgeführt und werden indirekt elektrisch über eine State-Machine zeitlich koordiniert betätigt.

Der Nachteil dieser Schaltgeräte besteht darin, dass eine zwangsbetätigte Öffnung der galvanischen Kontakte nicht möglich ist. Es gibt zudem keine normgemäße Trennereigenschaft und keine galvanische Öffnung im Überlastfall.

Aus der EP 2 234 136 A1 ist ein Gleichstromschalter bekannt, der eine Kontakteinheit aufweist. Die Kontakteinheit weist mechanische Kontakte und einen mit den mechanischen Kontakten in Reihe geschalteten Halbleiterschalter auf. Der Gleichstromschalter umfasst weiterhin eine Schaltmechanismuseinheit mit einem Betätigungsgriff, der zur manuellen Betätigung dient und beweglich am Gehäuse befestigt ist, eine Positionserkennungseinheit zur Erkennung einer Betätigungsposition des Betätigungsgriffs und eine Steuereinheit. Die Steuereinheit schaltet die Kontakteinheit aus, wenn ein Überstrom auftritt. Die Steuereinheit ist dabei so konfiguriert, dass sie zuerst den Halbleiterschalter ausschaltet und dann einen Auslöser steuert, um die mechanischen Kontakte auszuschalten, wodurch die Kontakteinheit ausgeschaltet wird.

Aus der WO 2014/110625 A1 ist ein Schaltmodul zum Verbinden einer Last mit einer Wechselstromversorgung bekannt, das einen elektromechanischen Schalter umfasst, wobei elektrische Energie nicht erforderlich ist, um den verriegelten offenen Zustand oder den verriegelten geschlossenen Zustand aufrechtzuerhalten, wobei das Schaltmodul ferner einen Halbleiterschalter in Reihe mit dem elektromechanischen Schalter aufweist sowie ein Steuermodul zum periodischen Ansteuern des Halbleiterschalters von einem Ein-Zustand zu einem AusZustand während eines Teils eines Wechselstromzyklus und eine Speichervorrichtung, die aus dem Spannungsabfall über dem den Halbleiterschalter gespeist wird und die den Halbleiterschalter ansteuert und ein elektrisches AUS-Signal an den elektromechanischen Schalter bereitstellt.

Die Aufgabe der vorliegenden Erfindung besteht darin, ein elektronisches Schaltgerät nach dem oben dargelegten Anforderungsprofil zu konzipieren.

Diese Aufgabe wird erfindungsgemäß durch einen Schaltgerät nach Anspruch 1 gelöst. Vorteilhafte Aus- und Weiterbildungen, welche einzeln oder in Kombination miteinander eingesetzt werden können, sind der Gegenstand der abhängigen Ansprüche.

Erfindungsgemäß wird diese Aufgabe durch ein Schaltgerät gelöst mit:
- einer ersten, manuell mittels eines Bedienteils zu betätigenden, trennbaren Schaltstelle, wobei eine Veränderung des Drehwinkels des Bedienteils über ein drehwinkelpositionsabfragendes Element zu bestimmen ist, wodurch zu einem bestimmten Drehwinkel ein Signal erzeugt wird, welches an eine Auswertungs- und Ansteuereinheit weitergegeben wird und
- einer zweiten Schaltstelle, vorzugsweise einer Halbleiterschaltstelle, welche zeitlich voreilend zur ersten Schaltstelle stromkreisauftrennend wirkt, wobei zeitlich nachfolgend mittels eines Schaltzustandstransformators eine galvanische Trennung in einer Kontaktanordnung in der ersten Schaltstelle bewirkt wird,
wobei das Bedienteil (24) ein Bedienelement (2) umfasst, welches auf einen zylindrischen Körper (26) aufgesetzt ist und wobei an einem Endbereich des zylindrischen Körpers (26) das Bedienelement (2) und am anderen Endbereich ein vorstehender Kragen (27) am zylindrischen Körper (26) angeflanscht ist und wobei der vorstehende Kragen (27) das drehwinkelpositionsabfragende Element (25) bei einer entsprechenden Drehbewegung des Bedienteils (2) beaufschlagt.

Das erfindungsgemäße elektronische Schaltgerät bzw. Schutzschaltgerät weist vorzugsweise eine ein- oder zweipolige auftrennbare Schaltstelle auf sowie eine von einer kinematischen Stellvorrichtung betätigbare Schaltstelle für die galvanische Trennung eines Stromkreises. Diese galvanische Schaltstelle inklusive des Bedienteils kann zusammen mit der Halbleiterschaltstelle und den elektronischen Funktionsbausteinen auf der Ansteuerflachbaugruppe bzw. Leiterplatte in einem gemeinsamen Gerätegehäuse angeordnet sein oder in einem separaten getrennten, aber anbaubarem Gehäuse. In Serie dazu ist eine elektronisch schaltende Halbleiterschaltstelle beispielsweise IGBT's in Antiparallelschaltung oder vergleichbare Schaltungen geschaltet. Das erfindungsgemäße elektronische Schaltgerät verfügt außerdem über weitere elektronische Funktionsbausteine in Form eines Schaltkreises zur Ansteuerung des Halbleiterschaltelements für eine Schaltzustandsänderung.

Des Weiteren gibt es einen elektronischen Funktionsbaustein für einen Schaltkreis zur Differenzierung zwischen einem Nennbetriebsstrom, einem Überlaststrom oder einem Kurzschlussstrom, welcher eine elektronische Anbindung an die Ansteuerschaltung für das Halbleiterschaltelement aufweist, um im Fehlerfall ein Auslöse- bzw. Abschaltsignal zu generieren.

Zur Ableitung der Verlustwärme der Halbleiterschaltstelle dient ein Kühlelement beispielsweise in Form eines Kühlkörpers, welcher im elektronischen Schaltgerät eingebaut ist.

Das Schaltgerät verfügt außerdem über ein kundenseitig zu betätigendes Bedienelement, welches die unterschiedlichen Schaltstellungen, d.h. den eingeschalteten Zustand, den ausgeschalteten Zustand, die Anzeige für den Schaltstellungszustand "AUSGELÖST" sowie die Wiederherstellung nach einem ausgelösten Zustand wiedergibt. Das Bedienelement ist zudem derart ausgeführt, dass eine normgemäße Trennerfunktion auch bei verschweißten Kontakten gewährleistet ist.

Zusätzliche Funktionsbausteine des erfindungsgemäßen elektronischen Schaltgeräts können in einem Element mit einer Funktion als Schaltzustandstransformator bestehen, welches ein elektrisches Auslösesignal in eine mechanische Kraft-Weggröße für die Auslösung des magnetischen Auslösers umsetzt. Das elektrische Auslösesignal ist ein Stromfluss, welcher in die auf Magnetismus beruhenden Wirkprinzipien des magnetischen Auslösers eingreift. Dieser Schaltmechanismus erfordert einen auf- und entladbaren Energiespeicher beispielsweise in Form eines Kondensators für die elektrische Energie sowie eine elektromagnetische Feldspule für die Auslösung des zunächst über Magnetkraft in Ausgangsposition gehaltenen Auslösers.

Das elektronische Schaltgerät kann außerdem über eine Rückstellvorrichtung zur Rückführung des ausgelösten magnetischen Auslösers (MAGLATCH) in seine Ausgangs-Haltestellung verfügen, um seine erneute Auslösebereitschaft wiederherzustellen. Der entscheidende Vorteil des magnetischen Auslösers besteht darin, dass im Fehlerfall, neben dem vorauseilenden Abschalten der Halbleiterschaltstelle, im Nachgang eine zusätzliche, in Serie liegende galvanische Öffnungsstrecke stromlos geschaltet wird. Damit verbunden ist der weitere technische Vorteil, dass bei Vorliegen einer fehlerhaften, durchlegierten, d.h. niederohmigen Halbleiterschaltstelle, auch dann der Verbraucher sicher galvanisch vom Netz getrennt wird.

Eine weitere Zusatzfunktion des elektronischen Schaltgeräts kann in einem drehwinkelpositionsabfragenden Element bestehen, welches den Schaltstellungszustand des Bedienelements ermittelt, insbesondere für die Schaltstellungsänderung, kurz bevor, eingeleitet durch das Bedienelement, die Kniegelenk-Kinematik (Schaltschloss) seine eingeschaltete Stellung verlässt und in den ausgeschalteten Zustand wechselt. Diese Abfrage kann z.B. mittels eines handhabenbetätigten elektrischen Druckschalters auf der Platine umgesetzt sein. Dieser elektrische Druckschalter steht in Wirkverbindung mit der Ansteuerschaltung des oder der Halbleiterelemente.

Für den Fall, dass das Bedienelement von der eingeschalteten Stellung, vorzugsweise mit einem Winkel von 90° zur Einbauebene des elektromagnetischen Auslösers, ein Paar Grad in Richtung der ausgeschalteten Stellung gedreht wird, signalisiert dieser Druckschalter der IGBT-Ansteuerung ein Ausschalten der Halbleiterschaltstelle. Im weiteren Betätigungsdrehweg Richtung 0°, also in den ausgeschalteten Zustand, fährt die manuell zu betätigende, trennbare Schaltstelle in eine galvanisch getrennte Offenstellung.

Dazu muss zunächst der Totpunkt des mechanischen Kniegelenks, welcher vorzugsweise bei z.B. 72° liegt, durchlaufen werden. Ausgehend von der eingeschalteten Stellung mit einem Winkel von 90° bis zum Umsetzen des Kniegelenks bei vorzugsweise 72°, verbleibt so ein noch zurückzulegender Drehwinkel von 18°, welcher einen ausreichenden zeitlichen Versatz bildet, um den voreilenden Druckschalter zu betätigen.

Im Fall einer Überlast bleibt zunächst das Bedienelement in Stellung EIN 90°. Der elektronische Funktionsbaustein für Überlast erkennt diese und generiert über den Funktionsbaustein Halbleiteransteuerung zunächst ein Abschaltsignal an die Halbleiter-Schaltstelle. Diesem Vorgang zeitlich nachfolgend wird ein elektrisches Auslösesignal für den magnetischen Schaltzustandstransformator erzeugt, welcher seinerseits die Kniegelenk-Kinematik mechanisch freigibt, welche wiederum die erste Schaltstelle galvanisch öffnet.

Der große Vorteil des erfindungsgemäßen elektronischen Schaltgeräts besteht darin, dass durch das vorauseilende Schalten des Druckschalters und das funktionsgekoppelte Abschalten der Halbleiterschaltstelle die galvanische Öffnungsstelle stromlos geöffnet werden kann, so dass diese deutlich kleiner dimensioniert werden kann. Das führt dazu, dass durch das stromlose Öffnen auf lichtbogenführende und löschende Einrichtungen im Schaltgerät verzichtet werden kann. Dies führt zu einer platzoptimierten Bauweise. Es gibt zudem einen Kommunikationsbaustein, welcher eine spätere Busanbindung ermöglichen kann, sowie eine externe Spannungsversorgung des Schaltgeräts.

Es entspricht einer speziellen Ausführungsform des erfindungsgemäßen Konzepts, dass das Schaltgerät eine Auswerteelektronik aufweist, welche einen Schaltkreis für eine Ansteuerung eines Halbleiterschaltelements aufweist.

Eine spezielle Ausgestaltung des erfindungsgemäßen Konzepts kann darin bestehen, dass das Schaltgerät eine Kurzschluss-Überstromauswerteschaltung aufweist.

Es entspricht einer speziellen Ausführungsform des erfindungsgemäßen Konzepts, dass der auswertende Funktionsbaustein das Halbleiterschaltelement oder ein zusätzliches ist.

Eine Fortführung des erfindungsgemäßen Konzepts kann darin bestehen, dass das Schaltgerät als integriertes Schaltgerät ausgebildet ist, d.h., die Funktionen des Schaltgeräts sind in einem Gehäuse untergebracht.

Eine spezielle Ausgestaltung des erfindungsgemäßen Konzepts kann darin bestehen, dass das Schaltgerät als modulares Schaltgerät ausgebildet ist, d.h., die unterschiedlichen Funktionen des Schaltgeräts sind in einer Mehrzahl an Gehäuseumfassungen angeordnet.

Es entspricht einer speziellen Ausführungsform des erfindungsgemäßen Konzepts, dass das Bedienteil, der magnetische Auslöser sowie die Kontaktanordnung für die galvanische Trennung in einem ersten Gehäuse und die Leitungselektronik in einem zweiten Gehäuse ausgebildet sind. Unter dem Begriff Leistungselektronik wird hier die Umformung von elektrischer Energie mit schaltenden, elektronischen Bauelementen definiert. Dazu gehören die oben aufgeführten elektronischen Auswerteeinheiten.

Eine Fortführung des erfindungsgemäßen Konzepts kann darin bestehen, dass das Schaltgerät ein Element mit einer Funktion als Schaltzustandstransformator aufweist, welcher ein elektrisches Signal in eine Kraft/Weg-Übertragung im magnetischen Auslöser umsetzt.

Eine spezielle Ausgestaltung des erfindungsgemäßen Konzepts kann darin bestehen, dass das Schaltgerät eine mechanische Rückführvorrichtung aufweist, welche den magnetischen Auslöser nach Auslösung zurücksetzt.

Es entspricht einer speziellen Ausführungsform des erfindungsgemäßen Konzepts, dass das drehwinkelpositionsabfragende Element als elektrischer Druckschalter oder als induktiver Näherungsschalter oder als Hallsensor mit Magnetgeber oder in Form einer leiterplattenbestückbaren Lichtschrankenlösung auf einer Leiterplatte ausgebildet ist.

Eine Fortführung des erfindungsgemäßen Konzepts kann darin bestehen, dass das Schaltgerät einen Kommunikationsbaustein für eine Kommunikationsumgebung im Feld aufweist.

Eine spezielle Ausgestaltung des erfindungsgemäßen Konzepts kann darin bestehen, dass das Schaltgerät eine externe Spannungsversorgung aufweist.

Es entspricht einer speziellen Ausführungsform des erfindungsgemäßen Konzepts, dass der magnetische Auslöser einen mit einer Auslösefeder in Auslöserichtung beaufschlagten Stößel sowie eine Spule aufweist, wobei ein Stromfluss durch die Spule einen magnetischen Fluss H_{Spule} im Auslösefall erzeugt und wobei der Stößel in einer ersten angezogenen Schaltstellung durch einen magnetischen Fluss H_{Remanenz}, welcher durch ein Magnetremanenzsystem bedingt ist, in Schaltstellungsposition gehalten wird.

Eine Fortführung des erfindungsgemäßen Konzepts kann darin bestehen, dass der magnetische Auslöser einen Anker, einen Permanentmagneten und ein Zwischenjoch, welche teilweise von einem Außenjoch umgeben sind, eine Spule, welche das Zwischenjoch umgibt, und eine Rückstellfeder aufweist, welche den Anker umgibt, wobei die Bewegungsrichtung des Ankers parallel zur Ausrichtung der Spulenwindungen der Spule ausgebildet ist.

Eine spezielle Ausgestaltung des erfindungsgemäßen Konzepts kann darin bestehen, dass der magnetische Auslöser ein Joch aufweist, in welchem ein Permanentmagnet und eine Spule angeordnet sind, und einen Anker, welcher über eine vorgespannte Rückstellfeder am Joch positioniert ist, wobei die Bewegung des Ankers bei einem Stromfluss durch die Spule durch die vorgespannte Rückstellfeder als Rotationsbewegung ausgebildet ist.

Das erfindungsgemäße elektronische Schaltgerät weist eine erste Baueinheit auf, welche ein Bedienelement, einen Energiespeicher, einen magnetischen Auslöser sowie eine Kontaktanordnung aus einer beweglichen Kontaktbrücke mit Kontaktstücken und zwei dazu gegenüberliegenden fest positionierten Kontaktbrücken mit Kontaktstücken, welche die galvanische Öffnungsstelle ausbilden, aufweist. Die bewegliche Kontaktbrücke ist federnd gelagert. Die zweite Baueinheit des elektronischen Schaltgeräts weist eine Leiterplatte auf, welche über ein Element mit dem magnetischen Auslöser verbunden ist.

Das Element weist eine Funktion als Schaltzustandstransformator auf.

Weitere Ausführungen und Vorteile der Erfindung werden nachfolgend anhand von Ausführungsbeispielen sowie anhand der Zeichnung erläutert.

Dabei zeigt:
Fig. 1 in einer schematischen Übersichtsdarstellung einen Teilausschnitt eines erfindungsgemäßen elektronischen Schaltgeräts mit einem magnetischen Auslöser und dessen elektronischer Anbindung;
Fig. 2 in einer schematischen Ansicht von oben den Teilausschnitt des elektronischen Schaltgeräts nach Fig. 1;
Fig. 3 in einer perspektivischen Darstellung das Zusammenwirken eines Bedienteils des elektronischen Schaltgeräts mit einem drehwinkelpositionsabfragenden Element in der Ausgangsstellung;
Fig. 4 in einem vergrößerten perspektivischen Teilausschnitt die Stellung des Bedienteils zum drehwinkelpositionsabfragenden Element in der Ausgangsstellung gemäß Fig. 3;
Fig. 5 in einer perspektivischen Darstellung das Zusammenwirken des Bedienteils des elektronischen Schaltgeräts mit dem drehwinkelpositionsabfragenden Element in der Auslösestellung;
Fig. 6 in einem vergrößerten perspektivischen Teilausschnitt die Stellung des Bedienteils zum drehwinkelpositionsabfragenden Element in der Auslösestellung gemäß Fig. 5;
Fig. 7 in einer perspektivischen Darstellung das Zusammenwirken des Bedienteils des elektronischen Schaltgeräts mit dem drehwinkelpositionsabfragenden Element in der Bewegung von der Auslösestellung in die Ausgangsstellung;
Fig. 8 in einem vergrößerten perspektivischen Teilausschnitt die Stellung des Bedienteils zum drehwinkelpositionsabfragenden Element in der Bewegung von der Auslösestellung in die Ausgangsstellung gemäß Fig. 7;
Fig. 9 in einer perspektivischen Darstellung einen Teilausschnitt eines erfindungsgemäßen elektronischen Schaltgeräts mit einem magnetischen Auslöser und dessen elektronischer Anbindung in der Ausgangsstellung gemäß Fig. 3 und 4;
Fig. 10 in einer perspektivischen Darstellung einen Teilausschnitt eines erfindungsgemäßen elektronischen Schaltgeräts mit einem elektromagnetischen Auslöser und dessen elektronischer Anbindung in der Auslösestellung gemäß Fig. 5 und 6;
Fig. 11 in einer schematischen Darstellung ein erstes Ausführungsbeispiel eines magnetischen Auslösers ohne Flussverstärkung durch ein ferromagnetisches Joch mit einem Magnetremanenzsystem im Ausgangszustand;
Fig. 12 in einer schematischen Darstellung den magnetischen Auslöser nach Fig. 11 mit Flussverstärkung durch ein ferromagnetisches Joch mit einem Magnetremanenzsystem im Ausgangszustand;
Fig. 13 in einer schematischen Darstellung den magnetischen Auslöser nach Fig. 11 mit Flussverstärkung durch ein ferromagnetisches Joch mit einem Magnetremanenzsystem im Auslösefall;
Fig. 14 in einer schematischen Darstellung ein zweites Ausführungsbeispiel eines magnetischen Auslösers mit gewinkeltem Aufbau, im Schaltungszustand, wenn die magnetische Kraft größer ist als die Federkraft und die Spule stromlos vorliegt;
Fig. 15 in einer schematischen Darstellung das Ausführungsbeispiel nach Fig. 14, im Schaltungszustand, wenn die Federkraft größer ist als die Summe aus magnetischer Kraft und der Kraft der Spule;
Fig. 16 in einer schematischen Darstellung ein Ausführungsbeispiel in Anlehnung an die Ausführungsform der Fig. 14 und 15 des magnetischen Auslösers mit gewinkeltem Aufbau, wobei hier die Spulenwindungen auf einer Leiterplatte positioniert sind;
Fig. 17 in einer schematischen Darstellung ein drittes Ausführungsbeispiel eines magnetischen Auslösers für ein erfindungsgemäßes elektronisches Schaltgerät;
Fig. 18 in einer schematischen Draufsicht den Anker des magnetischen Auslösers nach Fig. 17 im Schaltungszustand einer stromlos ausgebildeten Spule;
Fig. 19 in einer schematischen Draufsicht der Anker des magnetischen Auslösers nach den Fig. 17 und 18 im Schaltungszustand einer stromdurchflossenen Spule.

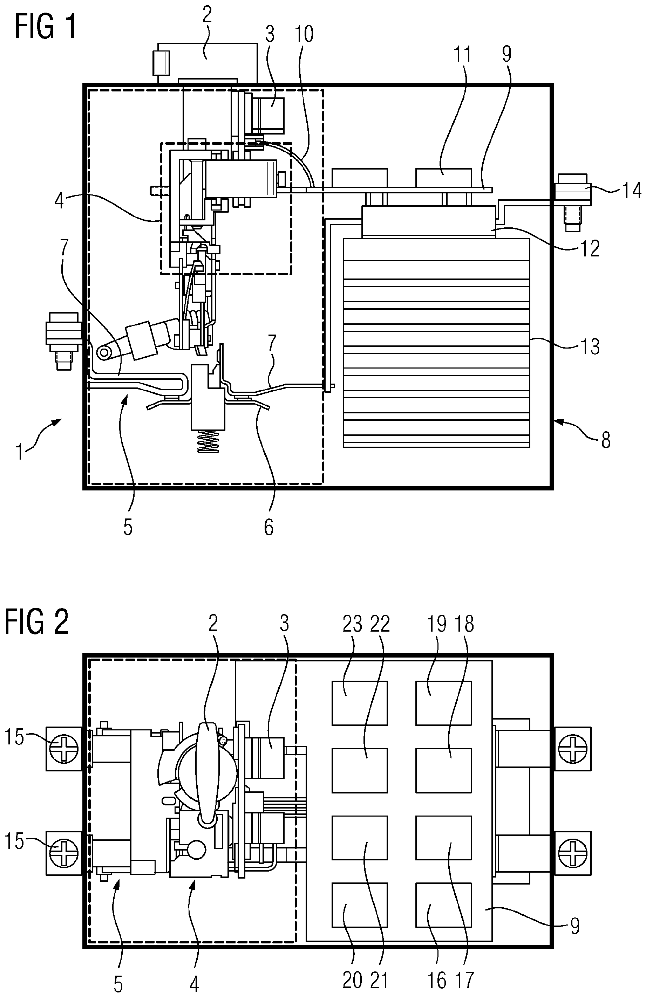

Fig. 1 zeigt einen Teilausschnitt eines erfindungsgemäßen elektronischen Schaltgeräts mit einem magnetischen Auslöser und dessen elektronische Anbindung. Das elektronische Schaltgerät weist eine erste Baueinheit 1 auf, welche ein Bedienelement 2, einen Energiespeicher 3, einen magnetischen Auslöser 4 sowie eine Kontaktanordnung 5 aus einer beweglichen Kontaktbrücke 6 mit Kontaktstücken und zwei dazu gegenüberliegenden fest positionierten Kontaktbrücken 7 mit Kontaktstücken, welche die galvanische Öffnungsstelle ausbilden, aufweist. Die bewegliche Kontaktbrücke ist federnd gelagert. Die zweite Baueinheit 8 des elektronischen Schaltgeräts weist eine Leiterplatte 9 auf, welche über ein Element 10 mit dem magnetischen Auslöser 4 verbunden ist. Das Element 10 weist eine Funktion als Schaltzustandstransformator auf. In der zweiten Baueinheit befindet sich außerdem ein Kühlelement 13 für das Halbleiterschaltelement 12. Außerhalb des Gehäuses sind Klemmanschlüsse 14 angeordnet. Die beiden Baueinheiten 1, 8 des elektronischen Schaltgeräts können in einem Gehäuse oder weitest gehend getrennt in unterschiedlichen Gehäusen angeordnet sein.

Fig. 2 zeigt den Teilausschnitt des elektronischen Schaltgeräts nach Fig. 1 von oben. In dieser Darstellung ist die erste Baueinheit 1 mit dem Bedienelement 2, dem Energiespeicher 3, dem magnetischen Auslöser 4, der Kontaktanordnung 5 sowie Klemmanschlüssen 15 dargestellt. Die zweite Baueinheit 8 ist im Wesentlichen in Form der Leiterplatte 9 wiedergegeben, wobei auf der Leiterplatte 9 unterschiedliche Funktionsbausteine angeordnet sind. Die Funktionsbausteine umfassen eine Ansteuerschaltung 16 für das Halbleiterschaltelement 12, eine Stromauswertungseinheit 17, eine Kurzschluss- Überlaststromauswerteschaltung 18, eine Spannungsüberwachung 19, eine Vorladeschaltung 20, eine EMV-Komponente 21, einen Kommunikationsbaustein 22 sowie eine Spannungsversorgung 23.

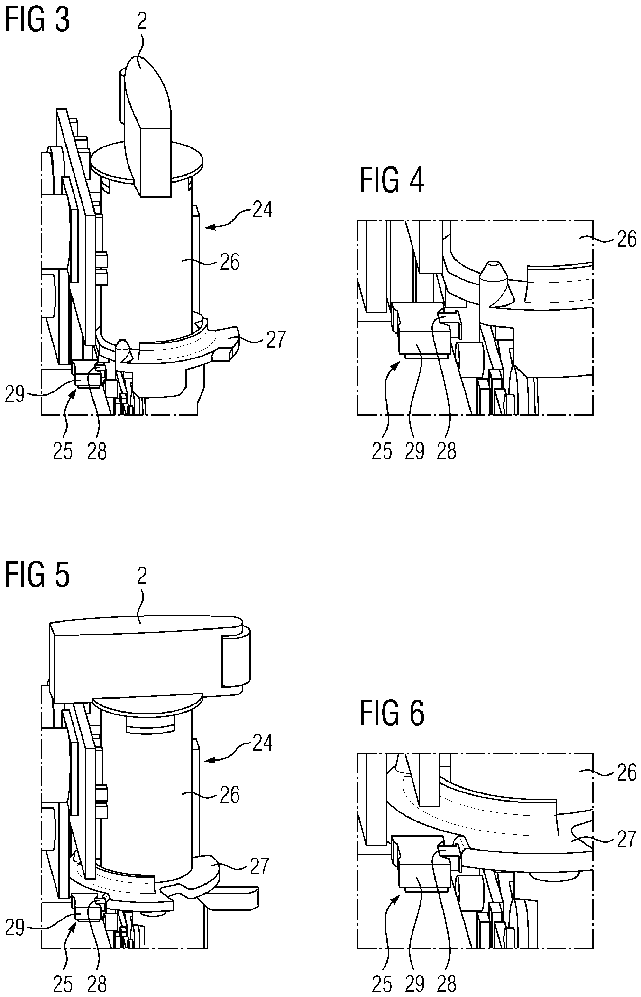

In Fig. 3 ist das Zusammenwirken des Bedienteils 24 mit Bedienelement 2 des elektronischen Schaltgeräts mit einem drehwinkelpositionsabfragenden Element 25 in der Ausgangsstellung dargestellt. Das Bedienteil 24 umfasst das Bedienelement 2, welches auf einen zylindrischen Körper 26 aufgesetzt ist. An einem Endbereich des zylindrischen Körpers 26 ist das Bedienteil 12 am anderen Endbereich ist ein vorstehender Kragen 27 am zylindrischen Körper 26 angeflanscht. Der vorstehende Kragen 27 beaufschlagt das drehwinkelpositionsabfragende Element 25 bei einer entsprechenden Drehbewegung des Bedienteils 2. Das drehwinkelpositionsabfragende Element 25 weist ein vorzugsweise in einer Ebene beweglich ausgeführtes Bauteil 28 auf, welches bei Beaufschlagung durch den vorstehenden Kragen 27 vorzugsweise in eine Gehäuseumfassung 29 gedrückt wird. Das drehwinkelpositionsabfragende Element 25 ist vorzugsweise federnd in der Gehäuseumfassung 29 gelagert. In Fig. 3 ist das Bedienteil 24 in seiner Ausgangsstellung mit einem Winkel von 0° zur Einbauebene des magnetischen Auslösers dargestellt.

Fig. 4 zeigt in einem vergrößerten Teilausschnitt die Stellung des vorstehenden Kragens 27 am zylindrischen Körper 26 bzw. des Bedienteils 24 zum drehwinkelpositionsabfragenden Element 25.

In Fig. 5 ist das Zusammenwirken des Bedienteils 24 des elektronischen Schaltgeräts mit dem drehwinkelpositionsabfragenden Element 25 in der Auslösestellung dargestellt. Das Bedienelement 2 steht nun in einem Winkel von 90° zur Einbauebene des magnetischen Auslösers 100, 200, 300. Der vorstehende Kragen 27 des zylindrischen Körpers 26 kann vorzugsweise mit einer Ausnehmung ausgeführt sein.

Fig. 6 zeigt in einem vergrößerten Teilausschnitt die Stellung des Bedienteils zum drehwinkelpositionsabfragenden Element 25 in der Auslösestellung mit einem Winkel von 90° zwischen Bedienelement 2 und Einbauebene des magnetischen Auslösers.

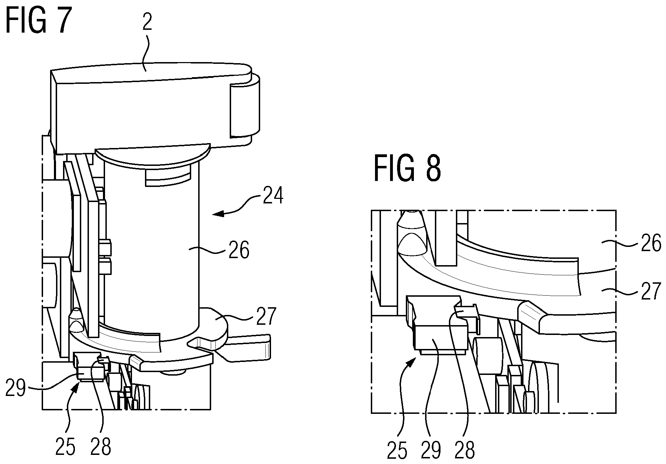

In Fig. 7 ist das Zusammenwirken des Bedienteils 24 des elektronischen Schaltgeräts mit dem drehwinkelpositionsabfragenden Element 25 in der Bewegung von der Auslösestellung in die Ausgangsstellung dargestellt. Diese Stellung ist durch einen Winkel von 72° zwischen Bedienelement 2 und der Einbauebene des magnetischen Auslösers charakterisiert. An diese Stellung ist die Öffnungsbewegung der galvanischen Schaltstelle gekoppelt.

Fig. 8 zeigt in einem vergrößerten Teilausschnitt die Stellung des Bedienteils zum drehwinkelpositionsabfragenden Element 25 in der Bewegung von der Auslösestellung in die Ausgangsstellung.

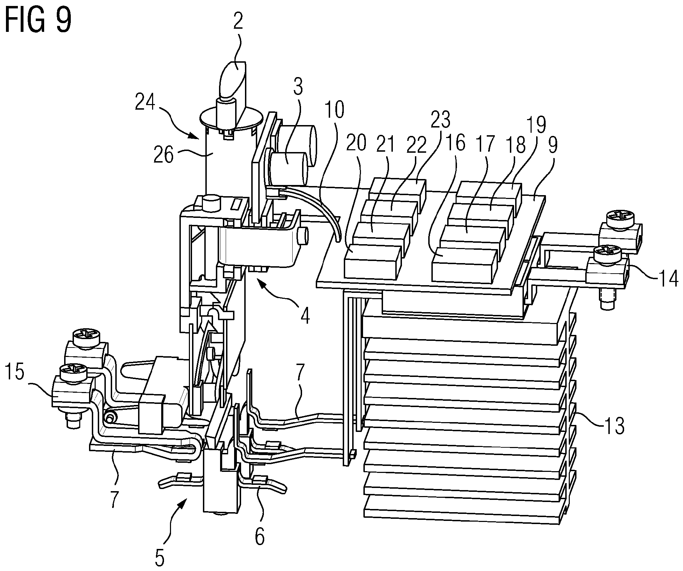

In Fig. 9 ist ein Teilausschnitt eines erfindungsgemäßen elektronischen Schaltgeräts mit einem magnetischen Auslöser und dessen elektronischer Anbindung in der Ausgangsstellung dargestellt.

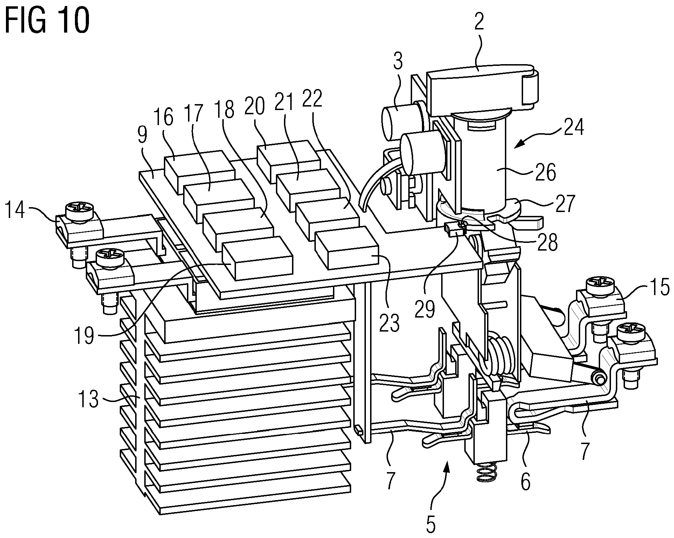

Fig. 10 zeigt einen Teilausschnitt des erfindungsgemäßen elektronischen Schaltgeräts mit einem magnetischen Auslöser und dessen elektronischer Anbindung in der Auslösestellung gemäß Fig. 4 und 4a.

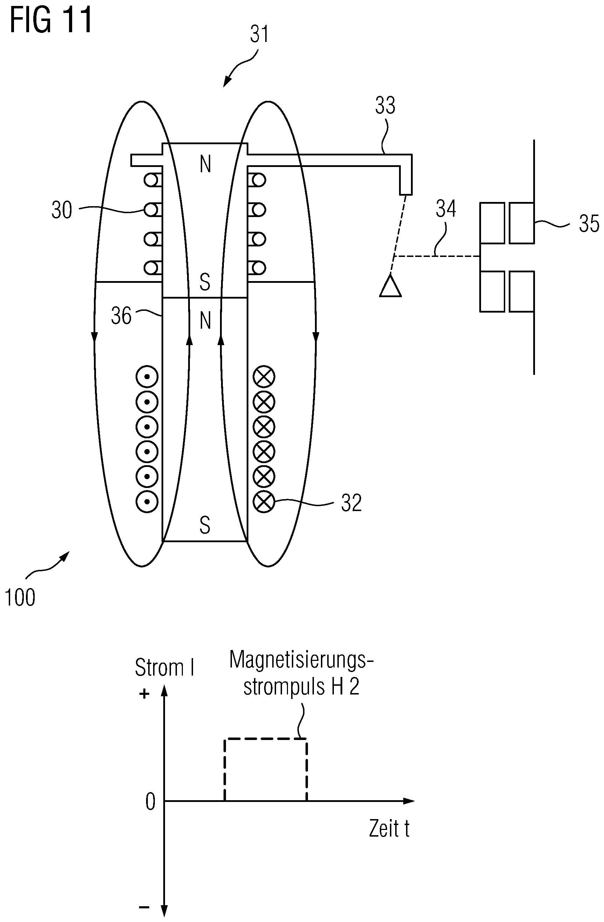

Fig. 11 zeigt ein erstes Ausführungsbeispiel eines magnetischen Auslösers 100 ohne Flussverstärkung durch ein ferromagnetisches Joch mit einem Magnetremanenzsystem im Ausgangszustand. Der magnetische Auslöser 100 weist eine Auslösefeder 30, welche in Auslöserichtung einen Stößel 31 beaufschlagt, sowie eine Spule 32 auf, wobei ein Stromfluss durch die Spule 32 einen magnetischen Fluss H_{Spule} im Auslösefall erzeugt. Der Stößel 31 ist mit einer Verklinkungsstelle 33 und die Verklinkungsstelle 33 mit einer Schaltkinematik 34 verbunden. Die Schaltkinematik 34 ist mit stromführenden Hauptkontakten 35 mechanisch verbunden, welche im Ausgangszustand geschlossen sind und im Auslösefall geöffnet vorliegen. In der Spule 32 ist ein Magnetremanenzsystem 36 in Form eines Polstücks angeordnet. Im Diagramm unterhalb dieser Anordnung ist ein Auftrag Strom gegen Zeit dargestellt, welcher den Magnetisierungsstrompuls H2 für den Ausgangszustand zeigt.

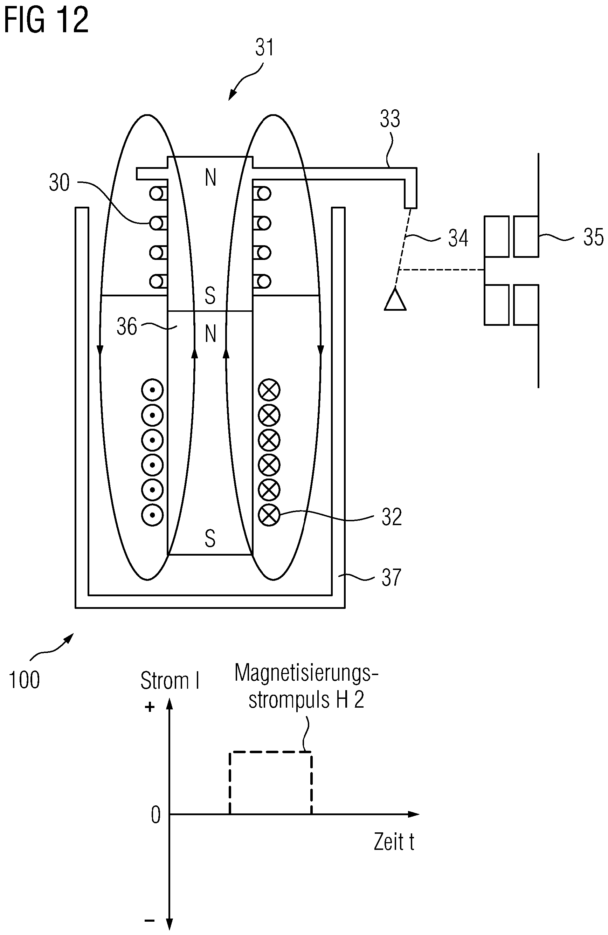

In Fig. 12 ist der magnetische Auslöser 100 mit Flussverstärkung durch ein ferromagnetisches Joch 37 mit einem Magnetremanenzsystem 36 im Ausgangszustand dargestellt. Im Diagramm unterhalb dieser Anordnung ist ein Auftrag Strom gegen Zeit dargestellt, welcher den Magnetisierungsstrompuls H2 für den Ausgangszustand zeigt.

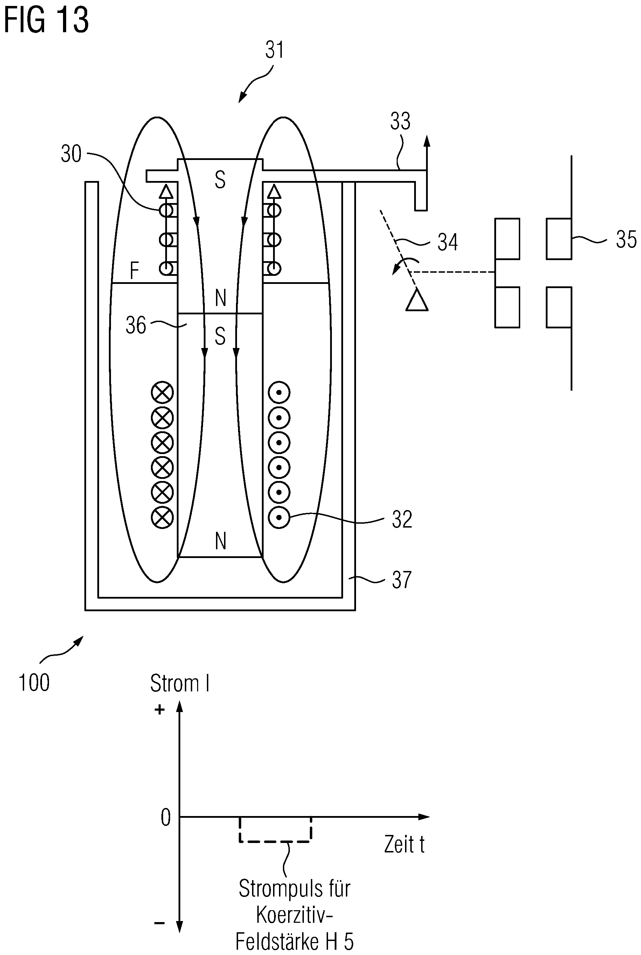

Fig. 13 zeigt den elektromagnetischen Auslöser 100 mit Flussverstärkung durch ein ferromagnetisches Joch 37 mit einem Magnetremanenzsystem 36 im Auslösefall. Im Diagramm unterhalb dieser Anordnung ist ein Auftrag Strom gegen Zeit dargestellt, welcher den Strompuls für die Koerzitiv-Feldstärke H5 für den Auslösezustand zeigt.

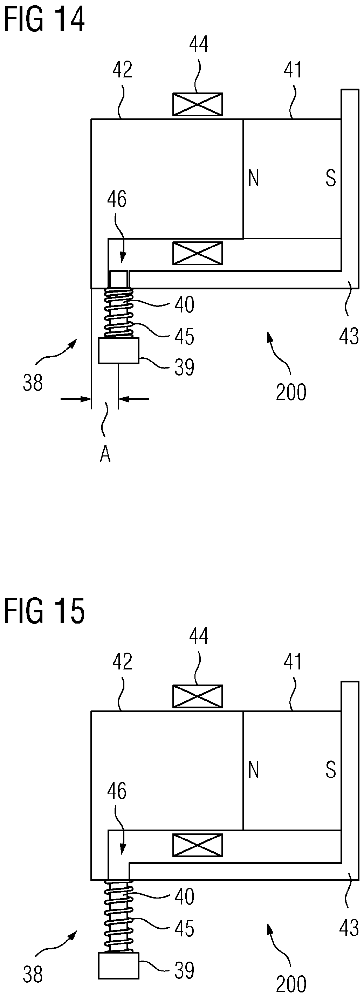

Fig. 14 zeigt ein zweites Ausführungsbeispiel eines magnetischen Auslösers 200 mit gewinkeltem Aufbau, im Schaltungszustand, wenn die magnetische Kraft größer ist als die Federkraft und die Spule stromlos vorliegt. Der magnetische Auslöser 200 für Schaltgeräte weist einen Anker 38, welcher an einem Ende einen Stempelaufsatz 39 und am anderen Ende einen Stempelendbereich 40 aufweist, einen Permanentmagneten 41 und ein Zwischenjoch 42, welche teilweise von einem Außenjoch 43 umgeben sind, eine Spule 44, welche das Zwischenjoch 42 umgibt, sowie eine Rückstellfeder 45 auf, welche den Stempelendbereich 40 des Ankers 38 umgibt. Der Anker 38 ist so im magnetischen Auslöser 200 positioniert, dass die Bewegungsrichtung des Ankers 38 parallel zur Ausrichtung der Spulenwindungen der Spule 44 ausgebildet ist. Dazu ist der Stempelendbereich 40 des Ankers 58 in einem Spalt 46 zwischen Zwischenjoch 42 und Außenjoch 43 gelagert.

In Fig. 15 ist das Ausführungsbeispiel nach Fig. 15 dargestellt im Schaltungszustand, wenn die Federkraft größer ist als die Summe aus magnetischer Kraft und Kraft der Spule 44. In diesem Fall vergrößert der Stempelendbereich 40 des Ankers 38 seinen Abstand zum Zwischenjoch 42.

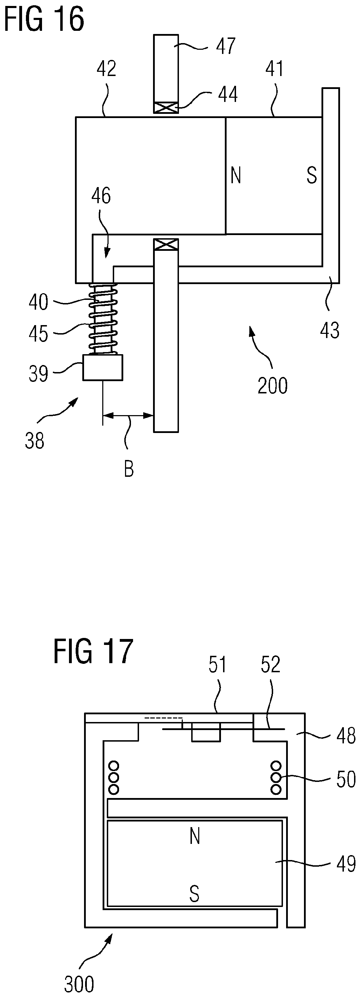

Fig. 16 zeigt in Anlehnung an das Ausführungsbeispiel aus den Fig. 15 und 16 den erfindungsgemäßen magnetischen Auslöser 200 mit gewinkeltem Aufbau, wobei hier die Spulenwindungen der Spule 44 im Bereich des Zwischenjochs 42 auf einer Leiterplatte 47 positioniert sind.

Fig. 17 zeigt ein drittes Ausführungsbeispiel eines elektromagnetischen Auslösers 300. Der magnetische Auslöser 300 weist ein Joch 48, in welchem ein Permanentmagnet 49 und eine Spule 50 angeordnet sind, und einen Anker 51 auf, welcher über eine vorgespannte Rückstellfeder 52 am Joch 48 positioniert ist. Die Bewegung des Ankers 51 ist bei einem Stromfluss durch die Spule 50 durch die vorgespannte Rückstellfeder 52, vorzugsweise eine Drehfeder, als Rotationsbewegung ausgebildet. Gleichzeitig kann dieser bifunktionale Anker 51 auch als Klinkenhebel innerhalb der Schaltkinematik eines Schaltschlosses angeordnet sein.

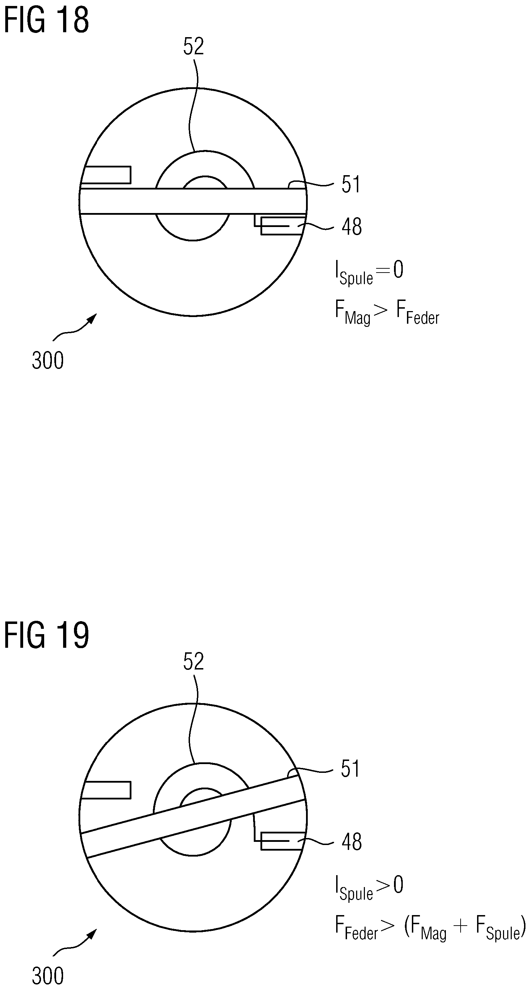

In Fig. 18 ist der Anker 51 des magnetischen Auslösers 300 im Schaltzustand einer stromlos ausgebildeten Spule 50 dargestellt. In diesem Fall ist die magnetische Kraft größer als die Federkraft.

In Fig. 19 ist der Anker 51 des magnetischen Auslösers 300 im Schaltzustand einer stromdurchflossenen Spule 50 dargestellt. In diesem Fall ist die Federkraft größer als die Summe der magnetischen Kraft und die Kraft der Spule.

Das erfindungsgemäße elektronische Schaltgerät zeichnet sich dadurch aus, dass durch das vorauseilende Schalten des Druckschalters und das funktionsgekoppelte Abschalten der Halbleiterschaltstelle die galvanische Öffnungsstelle stromlos geöffnet werden kann, so dass diese deutlich kleiner dimensioniert werden kann. Somit kann durch das stromlose Öffnen auf lichtbogenführende und löschende Einrichtungen im Schaltgerät verzichtet werden, so dass eine platzoptimierte Bauweise erreicht wird.

### Bezugszeichenliste

1 erste Baueinheit
2 Bedienelement
3 Energiespeicher
4 magnetischer Auslöser
5 Kontaktanordnung
6 Kontaktbrücke
7 Kontaktbrücke
8 zweite Baueinheit
9 Leiterplatte
10 Element
11 Ansteuereinheit
12 Halbleiterschaltelement
13 Kühlelement
14 Klemmanschluss
15 Klemmanschluss
16 Ansteuerschaltung
17 Stromauswertungseinheit
18 Kurzschluss- Überlaststromauswerteschaltung
19 Spannungsüberwachung
20 Vorladeschaltung
21 EMV-Komponente
22 Kommunikationsbaustein
23 Spannungsversorgung
24 Bedienteil
25 drehwinkelpositionsabfragende Element
26 zylindrischer Körper
27 vorstehender Kragen
28 Bauteil
29 Gehäuseumfassung
30 Auslösefeder
31 Stößel
32 Spule
33 Verklinkungsstelle
34 Schaltkinematik
35 Hauptkontakt
36 Magnetremanenzsystem
37 Joch
38 Anker
39 Stempelaufsatz
40 Stempelendbereich
41 Permanentmagnet
42 Zwischenjoch
43 Außenjoch
44 Spule
45 Rückstellfeder
46 Spalt
47 Leiterplatte
48 Joch
49 Permanentmagnet
50 Spule
51 Anker
52 Rückstellfeder
100 Magnetischer Auslöser
200 Magnetischer Auslöser
300 Magnetischer Auslöser

## Patentansprüche

1. Schaltgerät mit:
- einer ersten, manuell mittels eines Bedienteils (24) zu betätigenden, trennbaren Schaltstelle, wobei eine Veränderung des Drehwinkels des Bedienteils (24) über ein drehwinkelpositionsabfragendes Element (25) zu bestimmen ist, wodurch zu einem bestimmten Drehwinkel ein Signal erzeugt wird, welches an eine Auswertungs- und Ansteuereinheit weitergegeben wird, und
- einer zweiten Schaltstelle, welche zeitlich voreilend zur ersten Schaltstelle stromkreisauftrennend wirkt, wobei zeitlich nachfolgend mittels eines Schaltzustandstransformators eine galvanische Trennung in einer Kontaktanordnung (5) in der ersten Schaltstelle bewirkt wird,
**dadurch gekennzeichnet, dass**
- das Bedienteil (24) ein Bedienelement (2) umfasst, welches auf einen zylindrischen Körper (26) aufgesetzt ist und wobei an einem Endbereich des zylindrischen Körpers (26) das Bedienelement (2) und am anderen Endbereich ein vorstehender Kragen (27) am zylindrischen Körper (26) angeflanscht ist und wobei der vorstehende Kragen (27) das drehwinkelpositionsabfragende Element (25) bei einer entsprechenden Drehbewegung des Bedienteils (2) beaufschlagt.

2. Schaltgerät nach Anspruch 1, **dadurch gekennzeichnet, dass** das Schaltgerät eine Auswerteelektronik aufweist, welche einen Schaltkreis für die Ansteuerung eines Halbleiterschaltelements (12) aufweist.

3. Schaltgerät nach einem der Ansprüche 1 oder 2, **dadurch gekennzeichnet, dass** das Schaltgerät eine Kurzschluss-Überstromauswerteschaltung (18) aufweist.

4. Schaltgerät nach einem der Ansprüche 1 bis 3, **dadurch gekennzeichnet, dass** der auswertende Funktionsbaustein das Halbleiterschaltelement (12) oder ein zusätzliches ist.

5. Schaltgerät nach einem der Ansprüche 1 bis 4, **dadurch gekennzeichnet, dass** das Schaltgerät als modulares Schaltgerät ausgebildet ist.

6. Schaltgerät nach Anspruch 5, **dadurch gekennzeichnet, dass** das Bedienteil (24), der magnetische Auslöser (100, 200, 300) sowie die Kontaktanordnung (5) in einem ersten Gehäuse und die Leitungselektronik in einem zweiten Gehäuse ausgebildet sind.

7. Schaltgerät nach einem der Ansprüche 1 bis 6, **dadurch gekennzeichnet, dass** das Schaltgerät ein Element (10) mit einer Funktion als Schaltzustandstransformator aufweist, welcher ein elektrisches Signal in eine Kraft/Weg-Übertragung im magnetischen Auslöser (100, 200, 300) umsetzt.

8. Schaltgerät nach einem der Ansprüche 1 bis 7, **dadurch gekennzeichnet, dass** das Schaltgerät eine mechanische Rückführvorrichtung aufweist, welche den magnetischen Auslöser (100, 200, 300) nach Auslösung zurücksetzt.

9. Schaltgerät nach einem der Ansprüche 1 bis 8, **dadurch gekennzeichnet, dass** das drehwinkelpositionsabfragende Element (25) als elektrischer Druckschalter oder als induktiver Näherungsschalter oder als Hallsensor mit Magnetgeber oder in Form einer leiterplattenbestückbaren Lichtschrankenlösung auf einer Leiterplatte ausgebildet ist.

10. Schaltgerät nach einem der Ansprüche 1 bis 9, **dadurch gekennzeichnet, dass** das Schaltgerät einen Kommunikationsbaustein (22) für eine Kommunikationsumgebung im Feld aufweist.

11. Schaltgerät nach einem der Ansprüche 1 bis 10, **dadurch gekennzeichnet, dass** das Schaltgerät eine externe Spannungsversorgung (23) aufweist.

12. Schaltgerät nach einem der Ansprüche 1 bis 11, **dadurch gekennzeichnet, dass** der magnetische Auslöser (100) einen mit einer Auslösefeder (30) in Auslöserichtung beaufschlagten Stößel (31) sowie eine Spule (32) aufweist, wobei ein Stromfluss durch die Spule (32) einen magnetischen Fluss H_{Spule} im Auslösefall erzeugt und wobei der Stößel (31) in einer ersten angezogenen Schaltstellung durch einen magnetischen Fluss H_{Remanenz}, welcher durch ein Magnetremanenzsystem (36) bedingt ist, in Schaltstellungsposition gehalten wird.

13. Schaltgerät nach einem der Ansprüche 1 bis 12, **dadurch gekennzeichnet, dass** der magnetische Auslöser (200) einen Anker (38), einen Permanentmagneten (41) und ein Zwischenjoch (42), welche teilweise von einem Außenjoch (43) umgeben sind, eine Spule (44), welche das Zwischenjoch (42) umgibt, und eine Rückstellfeder (45) aufweist, welche den Anker (38) umgibt, wobei die Bewegungsrichtung des Ankers (38) parallel zur Ausrichtung der Spulenwindungen der Spule (44) ausgebildet ist.

14. Schaltgerät nach einem der Ansprüche 1 bis 12, **dadurch gekennzeichnet, dass** der magnetische Auslöser (300) ein Joch (48) aufweist, in welchem ein Permanentmagnet (49) und eine Spule (50) angeordnet sind, und einen Anker (51), welcher über eine vorgespannte Rückstellfeder(52) am Joch (48) positioniert ist, wobei die Bewegung des Ankers (51) bei einem Stromfluss durch die Spule (50) durch die vorgespannte Rückstellfeder (52) als Rotationsbewegung ausgebildet ist.

## Claims

1. Switching device having:
- a first separable switching point which is to be actuated manually by means of an operating device (24), wherein a change in the rotation angle of the operating device (24) is to be determined by a rotation angle position sensing element (25), whereby at a particular rotation angle a signal is generated which is passed on to an evaluation and control unit, and
- a second switching point which acts in a circuit-disconnecting manner temporally ahead of the first switching point, wherein galvanic isolation is brought about in a contact arrangement (5) in the first switching point temporally subsequently by means of a switching state transformer,
**characterized in that**
- the operating device (24) comprises an operating element (2) which is mounted on a cylindrical body (26) and wherein the operating element (2) is flanged to one end region of the cylindrical body (26) and a projecting collar (27) is flanged to the other end region on the cylindrical body (26) and wherein the projecting collar (27) acts upon the rotation angle position sensing element (25) in the case of a corresponding rotation movement of the operating device (2).

2. Switching device according to Claim 1, **characterized in that** the switching device has evaluation electronics which have a circuit for controlling a semiconductor switching element (12) .

3. Switching device according to either of Claims 1 and 2, **characterized in that** the switching device has a short-circuit overcurrent evaluation circuit (18).

4. Switching device according to one of Claims 1 to 3, **characterized in that** the evaluating function module is the semiconductor switching element (12) or an additional one.

5. Switching device according to one of Claims 1 to 4, **characterized in that** the switching device is designed as a modular switching device.

6. Switching device according to Claim 5, **characterized in that** the operating device (24), the magnetic trigger (100, 200, 300) and the contact arrangement (5) are formed in a first housing and the power electronics are formed in a second housing.

7. Switching device according to one of Claims 1 to 6, **characterized in that** the switching device has an element (10) having a function as a switching state transformer, which converts an electrical signal into a force/displacement transfer in the magnetic trigger (100, 200, 300).

8. Switching device according to one of Claims 1 to 7, **characterized in that** the switching device has a mechanical return apparatus which resets the magnetic trigger (100, 200, 300) after the latter has been triggered.

9. Switching device according to one of Claims 1 to 8, **characterized in that** the rotation angle position sensing element (25) is designed as an electric pressure switch or as an inductive proximity switch or as a Hall sensor having a magnetic encoder or is in the form of a printed circuit board-mountable light barrier solution on a printed circuit board.

10. Switching device according to one of Claims 1 to 9, **characterized in that** the switching device has a communication module (22) for a communication environment in the field.

11. Switching device according to one of Claims 1 to 10, **characterized in that** the switching device has an external power supply (23).

12. Switching device according to one of Claims 1 to 11, **characterized in that** the magnetic trigger (100) has a plunger (31) which is acted upon by a trigger spring (30) in the trigger direction, and a coil (32), wherein a current flow through the coil (32) generates a magnetic flux H_{coil} in the case of triggering and wherein the plunger (31) in a first retracted switching position is held in the switching position by a magnetic flux H_{remanence} caused by a magnetic remanence system (36).

13. Switching device according to one of Claims 1 to 12, **characterized in that** the magnetic trigger (200) has an armature (38), a permanent magnet (41) and an intermediate yoke (42) which are partially surrounded by an outer yoke (43), a coil (44) which surrounds the intermediate yoke (42), and a return spring (45) which surrounds the armature (38), wherein the direction of movement of the armature (38) is formed parallel to the orientation of the coil windings of the coil (44).

14. Switching device according to one of Claims 1 to 12, **characterized in that** the magnetic trigger (300) has a yoke (48) in which a permanent magnet (49) and a coil (50) are arranged, and an armature (51) which is positioned on the yoke (48) above a preloaded return spring (52), wherein when current flows through the coil (50) the movement of the armature (51) is in the form of a rotation movement by way of the preloaded return spring (52).

## Revendications

1. Appareil de commutation avec :
- un premier point de commutation séparable à actionner au moyen d'une unité de commande (24), dans lequel une modification de l'angle de rotation de l'unité de commande (24) est à déterminer par le biais d'un élément demandant la position d'angle de rotation (25), moyennant quoi un signal est généré au niveau d'un angle de rotation déterminé, lequel signal est transmis à une unité d'évaluation et de contrôle, et
- un second point de commutation qui agit à action temporellement avancée par rapport au premier point de commutation en séparant le circuit électrique, dans lequel une séparation galvanique dans un agencement de contact (5) est exercée dans le premier point de commutation ultérieurement au moyen d'un transformateur d'état de commutation,
**caractérisé en ce que**
- l'unité de commande (24) comprend un élément de commande (2) qui est posé sur un corps cylindrique (26) et dans lequel l'élément de commande (2) est bridé au niveau d'une zone d'extrémité du corps cylindrique (26) et au niveau de l'autre zone d'extrémité un col faisant saillie (27) est bridé au niveau du corps cylindrique (26) et dans lequel le col faisant saillie (27) alimente l'élément demandant la position d'angle de rotation (25) lors d'un mouvement de rotation correspondant de l'élément de commande (2).

2. Appareil de commutation selon la revendication 1, **caractérisé en ce que** l'appareil de commutation présente une électronique d'évaluation qui présente un circuit de commutation pour le contrôle d'un élément de commutation à semi-conducteur (12).

3. Appareil de commutation selon l'une quelconque des revendications 1 ou 2, **caractérisé en ce que** l'appareil de commutation présente un circuit d'évaluation de surintensité de court-circuit (18).

4. Appareil de commutation selon l'une quelconque des revendications 1 à 3, **caractérisé en ce que** le composant fonctionnel à évaluer est l'élément de commutation à semi-conducteur (12) ou un élément supplémentaire.

5. Appareil de commutation selon l'une quelconque des revendications 1 à 4, **caractérisé en ce que** l'appareil de commutation est configuré en tant qu'appareil de commutation modulaire.

6. Appareil de commutation selon la revendication 5, **caractérisé en ce que** l'unité de commande (24), le déclencheur magnétique (100, 200, 300) ainsi que l'agencement de contact (5) sont configurés dans un premier boîtier et l'électronique de ligne est configurée dans un second boîtier.

7. Appareil de commutation selon l'une quelconque des revendications 1 à 6, **caractérisé en ce que** l'appareil de commutation présente un élément (10) avec une fonction en tant que transformateur d'état de commutation qui convertit un signal électrique en une transmission de force/course dans le déclencheur magnétique (100, 200, 300).

8. Appareil de commutation selon l'une quelconque des revendications 1 à 7, **caractérisé en ce que** l'appareil de commutation présente un dispositif de recirculation mécanique qui réinitialise le déclencheur magnétique (100, 200, 300) après le déclenchement.

9. Appareil de commutation selon l'une quelconque des revendications 1 à 8, **caractérisé en ce que** l'élément demandant la position d'angle de rotation (25) est configuré sur un circuit imprimé en tant que commutateur de pression électrique ou en tant que commutateur de proximité inductif ou en tant que capteur à effet Hall avec un transmetteur magnétique ou sous la forme d'une solution de barrière lumineuse pouvant être équipée de circuits imprimés.

10. Appareil de commutation selon l'une quelconque des revendications 1 à 9, **caractérisé en ce que** l'appareil de commutation présente un module de communication (22) pour un environnement de communication sur le terrain.

11. Appareil de commutation selon l'une quelconque des revendications 1 à 10, **caractérisé en ce que** l'appareil de commutation présente une alimentation en tension externe (23) .

12. Appareil de commutation selon l'une quelconque des revendications 1 à 11, **caractérisé en ce que** le déclencheur magnétique (100) présente un poussoir (31) précontraint avec un ressort de déclenchement (30) dans la direction de déclenchement ainsi qu'une bobine (32), dans lequel un flux de courant génère en cas de déclenchement un flux magnétique H_{Spule} à travers la bobine (32) et dans lequel le poussoir (31) est maintenu dans une première position de commutation enclenchée par le biais d'un flux magnétique H_{Remanenz}, lequel est conditionné par le biais d'un système rémanent à aimants (36) .

13. Appareil de commutation selon l'une quelconque des revendications 1 à 12, **caractérisé en ce que** le déclencheur magnétique (200) présente un ancrage (38), un aimant permanent (41) et une culasse intermédiaire (42) qui sont entourés partiellement par une culasse externe (43), une bobine (44) qui entoure la culasse intermédiaire (42) et un ressort de rappel (45) qui entoure l'ancrage (38), dans lequel la direction de mouvement de l'ancrage (38) est configurée parallèlement à l'orientation des spires de bobine de la bobine (44).

14. Appareil de commutation selon l'une quelconque des revendications 1 à 12, **caractérisé en ce que** le déclencheur magnétique (300) présente une culasse (48) dans laquelle un aimant permanent (49) et une bobine (50) sont agencés, et un ancrage (51) qui est positionné au niveau de la culasse (48) par-dessus un ressort de rappel prétensionné (52), dans lequel le mouvement de l'ancrage (51) est configuré en tant que mouvement de rotation par le biais du ressort de rappel prétensionné (52) lors d'un flux de courant à travers la bobine (50).
